# EUROPÄISCHE PATENTSCHRIFT

(11) **EP 3 447 786 B1**
(45) Veröffentlichungstag und Bekanntmachung des Hinweises auf die Patenterteilung: **24.06.2020**
(21) Anmeldenummer: 18189214.2
(22) Anmeldetag: 16.08.2018
(51) Int. Cl.: H01H 85/041

(54) **ELEKTRISCHES SICHERUNGSELEMENT**
ELECTRICAL FUSE ELEMENT
ÉLÉMENT DE SÉCURITÉ ÉLECTRIQUE

(30) Priorität: 22.08.2017 DE 102017214682
(43) Veröffentlichungstag der Anmeldung: 27.02.2019
(73) Patentinhaber: LEONI Bordnetz-Systeme GmbH, 97318 Kitzingen (DE)
(72) Erfinder: DAUER, Michael, 97288 Theilheim (DE); FRANK, Tino, 97359 Schwarzach am Main (DE)
(74) Vertreter: FDST Patentanwälte

(56) Entgegenhaltungen:
- EP-A1- 0 314 895
- EP-A2- 0 471 922
- CN-U- 204 013 435
- US-A1- 2017 236 675

## Beschreibung

Die Erfindung betrifft ein elektrisches Sicherungselement.

Elektrische Sicherungselemente sind in nahezu jeder elektrischen Schaltung und / oder jedem elektrischen Stromkreis zu einem Überstromschutz angeordnet.

Sicherungselemente sind häufig als sogenannte Schmelzsicherungen ausgebildet und werden beispielsweise im Kraftfahrzeug-Bereich (Kfz-Bereich) eingesetzt. Schmelzsicherungen weisen üblicherweise ein von einem Isoliergehäuse eingehaustes Blechstanzbiegeteil mit einem Sicherungsbereich mit einem Schmelzleiter auf, durch den ein Strom eines zu sichernden Stromkreises fließt. Steigt der Wert des Stromes, beispielsweise aufgrund eines Kurzschlusses an und übersteigt der Wert des Stromes einen Stromschwellwert, so schmilzt der Schmelzleiter und "öffnet" somit den Stromkreis zum Schutz an den Stromkreis angeschlossener elektrischer Geräte und / oder Bauteile.

Derartige Sicherungselemente sind auch in elektrischen Schaltungen auf Leiterplatten, vorzugsweise zum Schutz von elektrischen Leitungen, beispielsweise in einem Kraftfahrzeug angeordnet. Die Sicherungselemente weisen üblicherweise zumindest zwei als Kontaktbeine bezeichnete Kontaktelemente auf, mit denen sie im montierten Zustand in einen Sicherungsträger eingesteckt sind. Der Sicherungsträger ist beispielsweise ein Blechbiegestanzteil oder auch eine Leiterplatte, durch die die Kontaktelemente hindurch gesteckt sind.

Das heutige Bestücken von Leiterplatten mit Sicherungselementen ist teilweise aufwändig.

Aus der EP 0 471 922 A2, der EP 0 314 895 A1 sowie der US 2017/0236675 A1 sind jeweils Sicherungselemente zur liegenden Anordnung auf einer Leiterplatte zu entnehmen. Zur Kontaktierung mit der Leiterplatte treten beidendseitig aus einem Gehäuse des Sicherungselementes jeweils Kontaktelemente heraus, die in einer Ausnehmung an der Unterseite des Gehäuses aufgenommen werden können.

Ausgehend hiervon liegt der Erfindung die Aufgabe zugrunde, ein elektrisches Sicherungselement anzugeben, welches einfach montierbar ist. Der Erfindung liegt weiterhin die Aufgabe zugrunde, eine Leiterplatte mit einem derartigen Sicherungselement anzugeben.

Die Aufgabe wird erfindungsgemäß gelöst durch ein elektrisches Sicherungselement für eine Anordnung auf einer Leiterplatte.

Das elektrische Sicherungselement weist ein insbesondere quaderförmiges Isoliergehäuse mit zwei gegenüberliegenden Hauptseiten, einer Unterseite sowie einer der Unterseite gegenüberliegenden Oberseite auf. Weiterhin weist das Isoliergehäuse zwei gegenüberliegende und die beiden gegenüberliegenden Hauptseiten verbindende Schmalseiten auf. Für die Anordnung auf der Leiterplatte und zur elektrischen Verbindung weist das elektrische Sicherungselement zwei Kontaktelemente auf. Die Kontaktelemente sind an der Unterseite des Isoliergehäuses angeordnet und treten an dieser aus dem Isoliergehäuse heraus. Der heraustretende Teilbereich der Kontaktelemente weist endseitig Kontaktflächen aus insgesamt ist der heraustretende Teilbereich abgewinkelt ausgebildet. Die Kontaktelemente treten zunächst in einer Längsrichtung aus dem Isoliergehäuse heraus und sind bezüglich dieser Längsrichtung ein- oder auch mehrfach abgewinkelt.

Weiterhin ist an der Unterseite des Isoliergehäuses des Sicherungselements zumindest ein Stützelement angeordnet. Das Stützelement weist eine Stützfläche auf, mittels der ein Abstützen des Sicherungselements auf der Leiterplatte realisiert ist.

Das Sicherungselement ist insbesondere nach Art eines Surface-Mounted-Device-Bauteil (SMD-Bauteil) ausgebildet. Unter einem SMD-Bauteil wird allgemein ein insbesondere elektronisches Bauteil verstanden, welches mittels Kontaktflächen mittels einer Oberflächenmontage (surface-mounting technology, SMT) auf der Leiterplatte angeordnet, beispielsweise gelötet ist. Unter Leiterplatte werden vorliegend gemäß dem allgemeinen Sprachgebrauch eine Platine und insbesondere eine gedruckte Schaltung beispielsweise nach Art eines Printed-Circuit-Bords verstanden. Durch die abgewinkelte Ausgestaltung des heraustretenden Teilbereichs werden die Kontaktflächen in eine günstige Orientierung parallel zur Oberfläche gebracht, auf der das Sicherungselement angeordnet wird.

Hierdurch ist ein Sicherungselement realisiert, welches einfach mittels Standard-SMD-Verfahren auf der Leiterplatte angeordnet werden kann. Durch die Ausgestaltung als ein SMD-fähiges Element werden insbesondere folgende Vorteile erzielt:
Zum Einen ist ein durchgängiger SMD-Fertigungsprozess ermöglicht. Auf der Leiterplatte werden üblicherweise weitere elektronische SMD-Bauteile angeordnet. Unter durchgängig wird vorliegend verstanden, dass die Fertigung einer derartigen SMD-Leiterplatte für einen vorgegebenen Zweck für eine Montage eines Sicherungselements nicht unterbrochen werden muss.

Weiterhin ist für eine Bestückung der Leiterplatte ein Einbringen von Stecklöchern nicht erforderlich, sodass ein Fertigungsschritt eingespart wird.

Zudem werden für die Bestückung Standard-Bestückungsverfahren, beispielsweise ein Pick & Place-Verfahren herangezogen.

Durch das Stützelement ist darüber hinaus eine zuverlässige Abstützung auf der Leiterplatte gewährleistet. Dieser Ausgestaltung liegt die Überlegung zugrunde, die Kontaktelemente, insbesondere die Kontaktflächen bezüglich der wirkenden Gewichtskraft und / oder bezüglich auftretender Kippmomente auf das montierte Sicherungselement in Richtung der Leiterplatte zu entlasten. Das Stützelement und die Stützfläche sind insbesondere als ein Teil des Isoliergehäuses nach Art einer einstückigen, insbesondere monolithischen Ausgestaltung ausgebildet. Alternativ sind das Kontaktelement und die Stützfläche als ein zusätzlicher Teil des Isoliergehäuses an diesem angeordnet, beispielsweise geklebt. Bei dem Isoliergehäuse handelt es sich bevorzugt um ein gegossenes Isoliergehäuse. Alternativ handelt es sich bei dem Isoliergehäuse um ein mehrteiliges Gehäuse. Einzelteile des Isoliergehäuses werden vorliegend im Rahmen der Fertigung des Sicherungselements miteinander stoffschlüssig verbunden, beispielsweise verklebt oder verschweißt.

Die Kontaktflächen und die Stützfläche sind innerhalb einer Ebene angeordnet. Durch die Anordnung innerhalb einer Ebene liegen die Kontaktflächen und die Stützfläche genau auf der Leiterplatte auf, sodass eine hohe Standfestigkeit gegeben ist. Alternativ oder ergänzend ist die Stützfläche mit der Leiterplatte stoffschlüssig verbunden, beispielswiese verklebt. Hierdurch ist weiterhin eine beidseitige Bestückung der Leiterplatte vor einem Verlöten ermöglicht, da bei einem Drehen der Leiterplatte während der und / oder zur Bestückung das Sicherungselement durch die stoffschlüssige Verbindung gehalten ist.

Zweckdienlicherweise sind die Kontaktflächen um einen Biegewinkel von 90° abgewinkelt angeordnet. Die Kontaktflächen sind daher bezüglich der erwähnten Längsrichtung rechtwinklig angeordnet. Der heraustretende Teilbereich ist dabei insbesondere L-förmig ausgebildet. Hierdurch ist eine insbesondere vertikal zu der Leiterplatte orientierte Anordnung des Sicherungselements ermöglicht. Mit anderen Worten: Das Sicherungselement wird hochkant auf der Leiterplatte angeordnet. Hierdurch wird insbesondere ein Vorteil hinsichtlich eines benötigten Platzbedarfes des Sicherungselements auf der Leiterplatte erreicht.

Bevorzugt ist das Sicherungselement als eine Schmelzsicherung ausgebildet. Die Schmelzsicherung weist vorzugsweise ein Blechbiegeteil auf, welches die beiden Kontaktelemente sowie einen Sicherungsbereich mit einem Schmelzleiter aufweist. Unter Schmelzsicherung wird vorliegend dem allgemeinen Sprachgebrauch ein Sicherungselement zum Schutz vor einem Überstrom innerhalb eines Stromkreises verstanden. Der Schmelzleiter schmilzt sobald ein durch ihn fließender Strom einen vorgegebenen Schwellwert übersteigt und trennt somit den Stromkreis auf.

Die Schmelzsicherung ist insbesondere nicht formschlüssig im Isoliergehäuse angeordnet. Mit anderen Worten: Die Schmelzsicherung, insbesondere der Schmelzleiter ist im Inneren des Isoliergehäuses beispielsweise frei in Luft angeordnet. Das Isoliergehäuse liegt somit nicht an dem Schmelzleiter an. Diese Anordnung wird auch als "Wire in Air Technologie" bezeichnet.

Das Sicherungselement ist allgemein als eine Flachsicherung ausgebildet und weist insbesondere außer dem Blechbiegeteil keine weiteren Komponenten auf.

Der Vorteil ist dieser Ausbildung ist, dass sich Schmelzsicherung insbesondere zum Schutz von Überströmen als besonders geeignet erwiesen haben und eine einfache und kostengünstige Realisierung eines Sicherungselements gewährleisten.

Zur elektrischen Kontaktierung mit der Leiterplatte sind bevorzugt zwischen den Kontaktflächen und der Leiterplatte dünne Kontaktbahnen oder Kontaktpads angeordnet.

Die Unterseite des Isoliergehäuses ist eine Schmalseite, sodass das Isoliergehäuse in Verbindung mit den bereits erwähnten und im rechten Winkel abgewinkelten Kontaktelementen in einer montierten Position orthogonal zu der Leiterplatte angeordnet ist. Mit anderen Worten: Aufgrund der Schmalseiten des Isoliergehäuses des Sicherungselements weist dieses eine quadratische Form nach Art eines "geplätteten" Quaders auf. In der montierten Position ist das Sicherungselement somit "hochkant" auf der Leiterplatte angeordnet. Das Sicherungselement ist also allgemein nach Art einer Flachsicherung ausgebildet, die senkrecht montiert ist.

Hierdurch ist insbesondere ein geringerer effektiver Flächenbedarf auf der Leiterplatte erreicht als beispielsweise bei einer Anordnung des Sicherungselements mit einer Hauptseite. Der geringe Flächenbedarf ist insbesondere hinsichtlich einem Einsatzgebiet des Sicherungselements und somit der Leiterplatte vorteilhaft, in dem eine Flächenbegrenzung für die Leiterplatte vorausgesetzt ist. Ein derartiges Einsatzgebiet ist beispielsweise die Automotive-Industrie.

Um eine kompakte Anordnung des Sicherungselements auf der Leiterplatte zu gewährleisten, stehen die Kontaktflächen gemäß einer zweckdienlichen Ausgestaltung maximal um eine Isoliergehäusebreite, vorzugsweise maximal um eine Hälfte der Isoliergehäusebreite seitlich über das Isoliergehäuse über.

Vorzugsweise weist die Oberseite des Isoliergehäuses eine plane Oberfläche auf. Unter planer Oberfläche wird vorliegend eine ebene Fläche verstanden, welche insbesondere keine Vertiefungen, Senken und / oder Verformungen (Beulen oder Dellen) aufweist. Der Vorteil in dieser Ausgestaltung ist in der Bestückung der Leiterplatte mit dem Sicherungselement zu sehen. D.h., dass insbesondere mechanisierte Verfahren, beispielsweise ein Pick & Place-Verfahren zur Bestückung der Leiterplatte herangezogen werden. Unter Bestückung wird vorliegend allgemein ein Anordnen von Bauteilen beispielsweise auf einer Leiterplatte verstanden. Üblicherweise erfolgt eine derartige Bestückung mittels des erwähnten Pick & Place-Verfahrens beispielsweise mittels eines mechanischen Unterdruck-Arms, welcher ein jeweiliges Bauteil mittels einer Düse ansaugt und auf eine vorgegebene Position auf einer Leiterplatte absetzt. Die plane Oberfläche hat sich als besonders geeignet erwiesen, um das Sicherungselement sicher mittels der Düse anzusaugen. Der Vorteil dieser Ausgestaltung ist in der Heranziehung von herkömmlichen SMD-Verfahren zu sehen. Somit ist kein zusätzliches Bestückungsverfahren für die Bestückung der Leiterplatte mit dem Sicherungselement erforderlich.

Zur Ausbildung eines Stoffschlusses, insbesondere einer Lötbarkeit, bei der Anordnung des Sicherungselements auf der Leiterplatte sind die Kontaktelemente vorzugsweise aus einem Metall und zumindest teilweise, beispielsweise die Kontaktflächen, veredelt. Unter Veredelung wird eine Beschichtung mit einem Veredelungsmetall beispielsweise Silber und / oder Zinn verstanden.

Gemäß einer bevorzugten Ausgestaltung weist das Isoliergehäuse einen Reflow-fähigen Kunststoff, beispielsweise ein flüssigkristallines Polymer (LCP) auf und ist vorzugsweise vollständig aus diesem gebildet. Unter Reflow-fähig wird vorliegend eine Eigenschaft eines Materials verstanden, bei der das Material während und / oder nach einem Lötverfahren, insbesondere nach Art eines Reflow-Lötverfahrens keine insbesondere thermische Beschädigung, beispielsweise Abschmelzungen, aufweist. Unter Reflow-Lötvorgang wird vorliegend ein bekanntes Lötverfahren zur Herstellung von Leiterplatten verstanden, bei dem vor dem Lötvorgang auf Stellen, auf die ein Bauteil gelötet wird, eine spezielle Lötpaste aufgetragen wird. Anschließend werden die Bauteile, beispielsweise mittels des Pick & Place-Verfahrens an ihrer jeweiligen Stelle auf der Leiterplatte angeordnet. Die zuvor aufgetragene Lötpaste dient hierbei einer provisorischen Fixierung der Bauteile nach Art eines Klebers. Erst nach der Bestückung der Leiterplatte erfolgt der eigentliche Lötvorgang, indem die gesamte Leiterplatte auf eine Temperatur mit einem Wert im Bereich von beispielsweise 250°C bis 300°C erhitzt wird, sodass sich die Lötpaste verflüssigt und die Bauteile nach einem Auskühlen auf der Leiterplatte irreversibel aufgelötet sind. Ein derartiges Lötverfahren ist insbesondere bei SMD-Leiterplatten eingesetzt.

Die Aufgabe wird erfindungsgemäß weiterhin gelöst durch eine Leiterplatte mit einem darauf angebrachten, insbesondere angelöteten elektrischen Sicherungselement, wie es zuvor beschrieben wurde.

Die im Hinblick auf das Sicherungselement aufgeführten Vorteile und bevorzugten Ausgestaltungen sind sinngemäß auf die Leiterplatte zu übertragen und umgekehrt.

Das Sicherungselement und die Leiterplatte sind vorzugsweise in einem Kraftfahrzeug eingesetzt. Die Leiterplatte ist beispielsweise in einem Sicherungskasten angeordnet.

Ein Ausführungsbeispiel der Erfindung wird nachfolgend anhand der Figuren näher erläutert. Diese zeigen teilweise in stark vereinfachten Darstellungen:
- Fig.1: eine perspektivische Ansicht eines elektrischen Sicherungselements,
- Fig.2: eine Seitenansicht des auf einer Leiterplatte angeordneten elektrischen Sicherungselements sowie
- Fig.3: eine Seitenansicht des zur Schmelzsicherung ausgebildeten Sicherungselements.

In den Figuren sind gleichwirkende Teile mit den gleichen Bezugszeichen dargestellt.

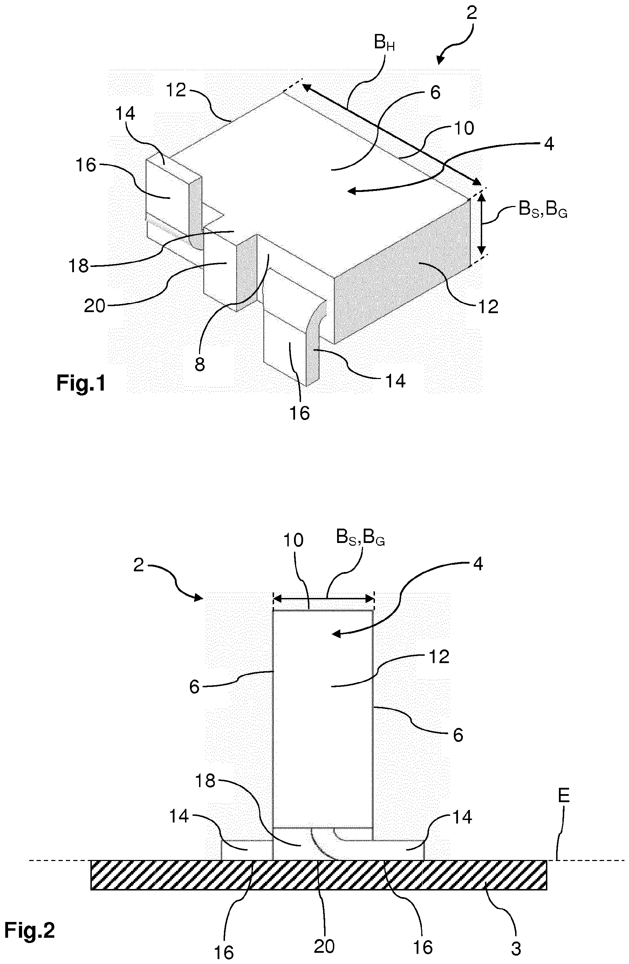

In Fig.1 ist eine Queransicht eines elektrischen Sicherungselements 2 für eine Anordnung auf einer Leiterplatte 3 (in Fig.2 dargestellt), beispielsweise ein Printed-Circuit-Board (PCB) dargestellt. Unter PCB wird vorliegend insbesondere eine gedruckte Schaltung und / oder eine Platine verstanden. Unter gedruckter Schaltung wird speziell eine Schaltung auf einer Leiterplatte verstanden, bei der die Leiterbahnen beispielsweise auf ein Trägermaterial der Leiterplatte "aufgedruckt" sind. Als Trägermaterial dient beispielsweise ein Kunststoff. Das Sicherungselement 2 ist im Ausführungsbeispiel als ein Surface-Mounted-Device Bauteil (SMD-Bauteil) ausgebildet.

Weiterhin weist das Sicherungselement 2 ein quaderförmiges Isoliergehäuse 4 mit zwei gegenüberliegenden Hauptseiten 6 (eine Hauptseite ist in Fig.1 nicht zu erkennen), einer Unterseite 8 sowie einer der Unterseite 8 gegenüberliegenden Oberseite 10 auf. Zur Ausbildung der Quaderform weist das Isoliergehäuse 4 zudem zwei gegenüberliegende Schmalseiten 12 auf. Das Isoliergehäuse 4 weist im Ausführungsbeispiel einen Reflow-fähigen Kunststoff, beispielsweise Polyetherketon oder ein flüssigkristallines Polymer (LCP) auf. Hierdurch ist insbesondere eine Anordnung des Sicherungselements 2 auf der Leiterplatte 3 mittels Standard-Verfahren ermöglicht.

Im Ausführungsbeispiel weist eine Breite B_{S} der Schmalseiten 12 einen geringeren Wert auf, als eine Breite B_{H} der Hauptseiten 6.

Die Breite B_{S} der Schmalseiten entspricht im Ausführungsbeispiel einer Isoliergehäusebreite B_{G}. Hierdurch ist das Sicherungselement 2 im Ausführungsbeispiel als eine Flachsicherung ausgebildet.

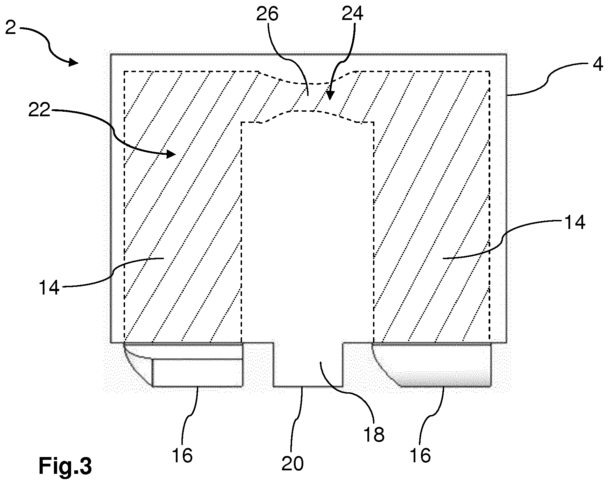

Zu einer elektrischen Verbindung mit der Leiterplatte 3 weist das Sicherungselement 2 zwei Kontaktelemente 14 auf. Die Kontaktelemente 14 treten an der Unterseite 8 des Isoliergehäuses 4 aus diesem heraus und weisen in einem rechten Winkel abgewinkelte Kontaktflächen 16 auf. Dabei sind die Kontaktflächen 16 jeweils in entgegengesetzte Richtungen zu einer jeweiligen Hauptseite 6 abgewinkelt. Die Kontaktelemente 14 sind Teil eines Blechbiegeteils 22 (in Fig.3 dargestellt)

In einem auf der Leiterplatte 3 angeordneten Zustand weist das Sicherungselement 2 eine orthogonal zur Leiterplatte 3 orientierte Ausrichtung auf. Mit anderen Worten: Das Sicherungselement 2 ist "hochkant" auf der Leiterplatte 3 angeordnet, beispielsweise aufgelötet, sodass die Oberseite 10 parallel zur Leiterplatte 3 orientiert ist.

Für eine zuverlässige Kontaktierung sind die Kontaktelemente 14 aus einem Metall, beispielsweise Kupfer oder Zink gebildet und zusätzlich zumindest teilweise veredelt, beispielsweise verzinnt oder versilbert. Unter zumindest teilweise veredelt wird vorliegend verstanden, dass zumindest die Kontaktflächen 16 beispielsweise verzinnt sind und so beispielsweise mittels eines Reflow-Verfahrens auf die Leiterplatte 3 auflötbar sind.

Im Ausführungsbeispiel weist die Oberseite 10 des Sicherungselements 2 eine plane Oberfläche auf. Unter planer Oberfläche wird vorliegend eine ebene Oberfläche verstanden, welche insbesondere beispielsweise keine Senken und / oder Rillen aufweist.

Aufgrund der planen Oberfläche ist insbesondere eine Bestückung der Leiterplatte 3 mit dem Sicherungselement 2 nach Art eines Pick & Place-Verfahrens ermöglicht. Bei einem derartigen Pick & Place-Verfahren werden die einzelnen Bauteile mittels einer Saugdüse, welche beispielsweise an einem von einem Computer gesteuerten Roboterarm angeordnet ist, angesaugt und auf der Leiterplatte 3 angeordnet. Um das Sicherungselement 2 mittels der Saugdüse aufzunehmen, ist eine derartige plane Oberfläche des Sicherungselements 2 essentiell.

Das Sicherungselement 2 weist im Ausführungsbeispiel weiterhin ein Stützelement 18 mit einer Stützfläche 20 auf. Das Stützelement 18 sowie die Stützfläche 20 dienen einem Abstützen des angeordneten Sicherungselements 2 auf der Leiterplatte 3, sodass die Kontaktelemente 14 vorzugsweise einer elektrischen Kontaktierung dienen und nicht zusätzlich das Gewicht des Sicherungselements 2 "tragen" müssen. Zusätzlich weist hierdurch das Sicherungselement Vorteile hinsichtlich einer Vibrationsresistenz auf.

In Fig.2 ist eine Seitenansicht des elektrischen Sicherungselements 2 dargestellt. Fig.2 unterliegt insbesondere keinem Maßstab. Die gezeigten Bauteile dienen ausschließlich der grafischen Verdeutlichung eines Ausführungsbeispiels der Erfindung.

Im Ausführungsbeispiel sind die Kontaktflächen 16 und die Stützfläche 20 in einer Ebene E angeordnet. Hierdurch ist ein Abstützen des Sicherungselements 2 auf der Leiterplatte 3 garantiert.

Weiterhin stehen die Kontaktflächen 16 im Ausführungsbeispiel maximal um die Hälfte der Isoliergehäusebreite B_{G} seitlich über das Isoliergehäuse 4 über. Alternativ stehen die Kontaktflächen 16 maximal um einen Wert der Isoliergehäusebreite B_{G} seitlich über das Isoliergehäuse über.

Dieser Ausgestaltung liegt insbesondere ein Zugewinn an Stabilität insbesondere hinsichtlich auftretender Seitenkräfte, im Vergleich zu einer Ausgestaltung bei der beispielsweise die Kontaktelemente 14 nicht seitlich über das Isoliergehäuse überstehen, zugrunde.

Das Sicherungselement 2 ist im Ausführungsbeispiel als eine Schmelzsicherung ausgebildet.

Fig. 3 zeigt eine derartige Ausbildung des Sicherungselements 2. Das Sicherungselement 2 weist hierzu ein Blechbiegeteil 22 auf, welches die Kontaktelemente 14 sowie die Kontaktflächen 16 aufweist. Zudem weist das Blechbiegeteil 22 einen Sicherungsbereich 24 mit einem Schmelzleiter 26 auf. Der Sicherungsbereich 24 verbindet die beiden Kontaktelemente 14 innerhalb des Isoliergehäuses 4 miteinander. Das Blechbiegeteil weist im Ausführungsbeispiel ein Metall, beispielsweise Zink auf und ist zumindest teilweise veredelt.

Im Folgenden wird noch einmal kurz auf die Funktionsweise einer derartigen Schmelzsicherung eingegangen:
Die Schmelzsicherung ist üblicherweise in einem zu schützenden Stromkreis angeordnet, sodass der Strom, welcher durch den Stromkreis fließt, auch durch die Schmelzsicherung fließt. Bei einem Überschreiten eines Stromschwellwertes, beispielsweise durch einen Kurzschluss in dem Stromkreis, schmilzt der Schmelzleiter 26 des Sicherungsbereiches 24 aufgrund der auftretenden thermischen Belastung. Hierdurch wird der Stromkreis "geöffnet" und ist somit stromfrei. Weitere an den Stromkreis angeschlossene Leitungen, Bauteile und / oder Geräte sind somit vor einem Überstrom geschützt.

Im Ausführungsbeispiel ist der Schmelzleiter 26 verjüngt ausgebildet. Die Verjüngung ist progressiv mit dem Stromschwellwert (Stromwert, ab dem die Schmelzsicherung "auslöst") korreliert. D.h. je dicker der Schmelzleiter 26, desto größer ist der Stromschwellwert, bei dem der Schmelzleiter 26 schmilzt. Hierdurch ist eine einfache Realisierung von Schmelzsicherungen für verschiedene abzusichernde Stromkreise für unterschiedliche Stromschwellwerte erreicht.

### Bezugszeichenliste

- 2: elektrisches Sicherungselement
- 3: Leiterplatte
- 4: Isoliergehäuse
- 6: Hauptseiten
- 8: Unterseiten
- 10: Oberseite
- 12: Schmalseite
- 14: Kontaktelement
- 16: Kontaktfläche
- 18: Stützelement
- 20: Stützfläche
- 22: Blechbiegeteil
- 24: Sicherungsbereich
- 26: Schmelzleiter
- B_{G}: Isoliergehäusebreite
- B_{H}: Breite der Hauptseite
- B_{S}: Breite der Schmalseite
- E: Ebene

## Patentansprüche

1. Elektrisches Sicherungselement (2) für eine Anordnung auf einer Leiterplatte (3) als SMD-Bauteil, welches aufweist
- ein Isoliergehäuse (4) mit einer Unterseite (8),
- zwei Kontaktelemente (14) zur elektrischen Verbindung mit der Leiterplatte (3), wobei die Kontaktelemente (14) jeweils an der Unterseite (8) des Isoliergehäuses (4) mit einem Teilbereich heraustreten, der endseitig eine Kontaktfläche (16) aufweist, die abgewinkelt ausgebildet ist,
**gekennzeichnet durch**
- zumindest ein Stützelement (18), welches an der Unterseite (8) angeordnet ist und das eine Stützfläche (20) zum Abstützen auf der Leiterplatte (3) aufweist, wobei
- die Kontaktflächen (16) und die Stützfläche (20) innerhalb einer Ebene (E) angeordnet sind,
- das Sicherungselement für eine Anordnung hochkant auf der Leiterplatte ausgebildet ist und das Isoliergehäuse (4) zwei gegenüberliegende Hauptseiten (6) sowie zwei gegenüberliegende Schmalseiten (12) aufweist, wobei eine Breite B_{S} der Schmalseiten (12) einen kleineren Wert aufweist als eine Breite B_{H} der Hauptseiten (6), und das Isoliergehäuse (4) in einer montierten Position orthogonal zu der Leiterplatte (3) angeordnet ist,
- die Kontaktflächen (16) jeweils in entgegengesetzten Richtungen zu einer jeweiligen Hauptseite (6) abgewinkelt sind.

2. Sicherungselement nach Anspruch 1 ,
wobei die endseitigen Kontaktflächen (16) um 90° abgewinkelt sind.

3. Sicherungselement nach einem der Ansprüche 1 bis 2,
welches als eine Schmelzsicherung ausgebildet ist.

4. Sicherungselement nach Anspruch 3,
wobei die Schmelzsicherung ein Blechbiegeteil (22) aufweist, welches die beiden Kontaktelemente (14) sowie einen Sicherungsbereich (24) mit einem Schmelzleiter (26) aufweist.

5. Sicherungselement (2) nach einem der Ansprüche 1 bis 4,
wobei das Isoliergehäuse (4) eine Isoliergehäusebreite (B_{G}) aufweist und die Kontaktflächen (16) maximal um die Isoliergehäusebreite (B_{G}) seitlich über das Isoliergehäuse (4) überstehen.

6. Sicherungselement (2) nach dem vorhergehenden Anspruch, bei dem die Kontaktflächen (16) maximal um die Hälfte der Isoliergehäusebreite (B_{G}) seitlich über das Isoliergehäuse (4) überstehen.

7. Sicherungselement (2) nach einem der Ansprüche 1 bis 6,
wobei eine Oberseite (10) des Isoliergehäuses (4) eine plane Oberfläche aufweist.

8. Sicherungselement (2) nach einem der Ansprüche 1 bis 7,
wobei die Kontaktelemente (14) aus einem Metall gebildet sind und zumindest teilweise veredelt sind.

9. Sicherungselement (2) nach einem der Ansprüche 1 bis 8,
wobei das Isoliergehäuse (4) einen Reflow-fähigen Kunststoff aufweist.

10. Leiterplatte (3) mit einem darauf angelöteten elektrischen Sicherungselement (2) nach einem der vorhergehenden Ansprüche, welches aufweist
- ein quaderförmiges Isoliergehäuse (4) mit einer Unterseite (8),
- zwei Kontaktelemente (14) zu einer elektrischen Verbindung mit der Leiterplatte (3), wobei die Kontaktelemente (14) mit einem Teilbereich aus dem Isoliergehäuse (4) heraustreten und der Teilbereich endseitig eine abgewinkelte Kontaktfläche (16) aufweist,
- zumindest ein Stützelement (18), welches an der Unterseite (8) angeordnet ist und eine Stützfläche (20) aufweist, die sich auf der Leiterplatte (3) abstützt.

11. Leiterplatte (3) nach dem vorhergehenden Anspruch, wobei die Kontaktelemente (14) über Lötstellen mit der Oberfläche der Leiterplatte (3) verlötet sind.

## Claims

1. Electrical fuse element (2) for an arrangement on a circuit board (3) as an SMD component, comprising
- an insulating housing (4) with an underside (8),
- two contact elements (14) for electrical connection to the circuit board (3), wherein the contact elements (14) each protrude from the underside (8) of the insulating housing (4) with a partial area which has a contact surface (16) of angled configuration at the end,
**characterised in**
- at least one support element (18) which is arranged on the underside (8) and which has a support surface (20) for support on the circuit board (3), wherein
- the contact surfaces (16) and the support surface (20) are arranged within one plane (E),
- the fuse element for an arrangement is formed edgewise on the circuit board and the insulating housing (4) has two opposite main sides (6) and two opposite narrow sides (12), wherein a width Bs of the narrow sides (12) is set to a smaller value than a width B_{H} of the main sides (6), and the insulating housing (4) is arranged orthogonal to the circuit board (3) in a mounted position,
- the contact surfaces (16) are each angled in opposite directions to a respective main side (6).

2. Fuse element according to Claim 1,
wherein the end contact surfaces (16) are angled by 90°.

3. Fuse element according to one of Claims 1 to 2,
which is designed as a safety fuse.

4. Fuse element according to Claim 3,
wherein the safety fuse has a bent sheet metal part (22) which comprises the two contact elements (14) and a fuse region (24) with a fusible conductor (26).

5. Fuse element (2) according to one of Claims 1 to 4,
wherein the insulating housing (4) has an insulating housing width (B_{G}) and the contact surfaces (16) protrude laterally beyond the insulating housing (4) by a maximum of the insulating housing width (B_{G}).

6. Fuse element (2) according to the preceding claim, in which the contact surfaces (16) protrude laterally beyond the insulating housing (4) by a maximum of half the insulating housing width (B_{G}).

7. Fuse element (2) according to one of Claims 1 to 6,
wherein an upper side (10) of the insulating housing (4) has a flat surface.

8. Fuse element (2) according to one of Claims 1 to 7,
wherein the contact elements (14) are formed from a metal and are at least partially refined.

9. Fuse element (2) according to one of Claims 1 to 8,
wherein the insulating housing (4) comprises a reflowable plastic.

10. Circuit board (3) with an electrical fuse element (2) soldered thereon according to one of the preceding claims, comprising
- a cuboid insulating housing (4) with an underside (8),
- two contact elements (14) for an electrical connection to the circuit board (3), wherein the contact elements (14) protrude with a partial region from the insulating housing (4) and the partial region has an angled contact surface (16) at the end,
- at least one support element (18) which is arranged on the underside (8) and has a support surface (20) which is supported on the circuit board (3).

11. Circuit board (3) according to the preceding claim, wherein the contact elements (14) are soldered to the surface of the circuit board (3) via soldering points.

## Revendications

1. Élément fusible électrique (2) pour un montage sur une carte de circuit imprimé (3) en tant que composant CMS, comprenant
- un boîtier isolant (4) avec une face inférieure (8),
- deux éléments de contact (14) pour la connexion électrique à la carte de circuit imprimé (3), les éléments de contact (14) dépassant chacun de la face inférieure (8) du boîtier isolant (4) avec une zone partielle qui présente une surface de contact (16) à l'extrémité qui est coudée,
**caractérisé par**
- au moins un élément de support (18) qui est disposé sur la face inférieure (8) et qui présente une surface d'appui (20) pour l'appui sur la carte de circuit imprimé (3), dans lequel
- les surfaces de contact (16) et la surface d'appui (20) sont disposées dans un même plan (E),
- l'élément fusible pour un dispositif est disposé sur chant sur le bord de la carte de circuit imprimé et le boîtier isolant (4) a deux côtés principaux opposés (6) et deux côtés étroits opposés (12), dans lequel une largeur Bs des côtés étroits (12) a une valeur inférieure à une largeur B_{H} des côtés principaux (6), et le boîtier isolant (4) est disposé orthogonalement à la carte de circuit imprimé (3) dans une position d'assemblage,
- les surfaces de contact (16) sont chacune inclinées dans des directions opposées par rapport à un côté principal respectif (6).

2. Élément fusible selon la revendication 1,
dans lequel les surfaces de contact des extrémités (16) sont inclinées de 90°.

3. Élément fusible selon l'une des revendications 1 à 2,
qui est conçu comme un fusible de sécurité.

4. Élément fusible selon la revendication 3,
dans lequel le fusible de sécurité a une pièce en tôle pliée (22) qui comporte les deux éléments de contact (14) et une zone de fusible (24) avec un conducteur fusible (26).

5. Élément fusible (2) selon l'une des revendications 1 à 4,
dans lequel le boîtier isolant (4) a une largeur de boîtier isolant (B_{G}) et les surfaces de contact (16) dépassent latéralement du boîtier isolant (4) au maximum d'une largeur de boîtier isolant (B_{G}).

6. Élément fusible (2) selon la revendication précédente, dans lequel les surfaces de contact (16) dépassent latéralement du boîtier isolant (4) au maximum de la moitié de la largeur du boîtier isolant (B_{G}).

7. Élément fusible (2) selon l'une des revendications 1 à 6,
dans lequel une face supérieure (10) du boîtier isolant (4) a une surface plane.

8. Élément fusible (2) selon l'une des revendications 1 à 7,
dans lequel les éléments de contact (14) sont formés d'un métal et sont au moins partiellement raffinés.

9. Élément fusible (2) selon l'une des revendications 1 à 8,
dans lequel le boîtier isolant (4) comporte un plastique pouvant être refondu.

10. Carte de circuit imprimé (3) avec un élément fusible électrique (2) soudé sur celle-ci selon l'une des revendications précédentes, ledit élément fusible comprenant
- un boîtier isolant en forme de parallélépipède (4) avec une face inférieure (8),
- deux éléments de contact (14) pour une connexion électrique à la carte de circuit imprimé (3), dans lequel les éléments de contact (14) dépassent hors du boîtier isolant (4) avec une zone partielle (4) et ladite zone partielle comprend à son extrémité une surface de contact (16) coudée,
- au moins un élément de support (18) disposé sur la face inférieure (8) et comprenant une surface de support (20) qui s'appuie sur la carte de circuit imprimé (3).

11. Carte de circuit imprimé (3) selon la revendication précédente, dans laquelle les éléments de contact (14) sont soudés à la surface de la carte de circuit imprimé (3) par l'intermédiaire de points de soudure.
